# EUROPEAN PATENT APPLICATION

(11) **EP 4 718 719 A1**
(43) Date of publication of application: **01.04.2026**
(21) Application number: 25202347.8
(22) Date of filing: 16.09.2025
(51) Int. Cl.: H03H 3/02, H03H 9/02, H03H 9/13, H03H 9/17

(54) **BULK ACOUSTIC WAVE DEVICE AND METHODS FOR FORMING THE SAME**

(30) Priority: 30.09.2024 US 202463701305 P
(71) Applicant: QORVO US, INC., Greensboro, NC 27409 (US)
(72) Inventor: SINGH, Sajal, Greensboro, 27409 (US); SADIK, Patrick W., Greensboro, 27409 (US); SADHU, Jyothi Swaroop, Greensboro, 27409 (US); MODARRES-ZADEH, Mohammad Jafar, Greensboro, 27409 (US)
(74) Representative: D Young & Co LLP

(57) **Abstract**

A method for forming a BAW device. The BAW device includes forming a dielectric layer over a reflector structure, forming an electrode seed material layer over the dielectric layer, forming an electrode material layer over the electrode seed material layer, patterning the electrode material layer to form an electrode layer and to expose the reflector structure, and forming a connection layer in contact with the electrode layer and the reflector structure.

## Description

### FIELD AND BACKGROUND

This disclosure relates to bulk acoustic wave (BAW) technologies. In particular, this disclosure relates to a BAW device and method for forming the BAW device.

Bulk acoustic wave (BAW) devices are widely used in modem electronics. At a high level, a BAW device often includes a layer of a piezoelectric material in contact with one or more electrodes. Piezoelectric materials acquire a charge when compressed, twisted, or distorted, and similarly, they compress, twist, or distort when a charge is applied to them. Accordingly, when an alternating electrical signal is applied to the one or more electrodes in contact with the piezoelectric material, a corresponding mechanical signal (i.e., an oscillation or vibration) is transduced therein.

Electrical loss in a BAW device can negatively affect performance. To meet certain filtering requirements in some applications (e.g., 5G networks), a BAW device is often operated at high frequencies and also often has thinner electrodes and/or smaller resonator areas. However, reducing the electrode thickness can result in increased resistance and increased electrical loss

### SUMMARY

Particular aspects are set out in the appended independent clzs. Various optional embodiments are set out in the dependent claims.

The presently disclosed techniques may provide, in at least some examples for reducing both the electrical loss and the material loss in a BAW device.

Aspects of the disclosure include a method for forming a BAW device. The BAW device includes forming a dielectric layer over a reflector structure, forming an electrode seed material layer over the dielectric layer, forming an electrode material layer over the electrode seed material layer, patterning the electrode material layer to form an electrode layer and to expose the reflector structure, and forming a connection layer in contact with the electrode layer and the reflector structure.

In some embodiments, the forming of the electrode seed material layer comprises depositing the electrode seed material layer to cover a top surface and a side surface of the dielectric layer, and the reflector structure.

In some embodiments, the electrode seed material layer comprises aluminum nitride (AlN).

In some embodiments, the depositing of the electrode seed material layer comprises an in-situ physical vapor deposition (PVD).

In some embodiments, the forming of the electrode material layer comprises depositing the electrode material layer to cover a top surface and a side surface of the electrode seed material layer, and the reflector structure.

In some embodiments, the depositing of the electrode material layer includes depositing a copper aluminum (AlCu) layer in contact with the electrode seed material layer, and depositing a tungsten (W) layer in contact with the copper aluminum layer.

In some embodiments, the depositing of the copper aluminum layer and the tungsten layer each comprises a physical vapor deposition (PVD).

In some embodiments, the forming of the connection layer includes depositing a first etch-stop material layer over the electrode material layer, and patterning the first etch-stop material layer and the electrode seed material layer in a same etching process that patterns the electrode material layer to expose the reflector structure, forming an electrode seed layer and a first etch-stop layer.

In some embodiments, the forming of the connection layer further includes depositing a conductive material layer over the electrode layer, the conductive material layer being in contact with the side surface of the electrode layer and the reflector structure, and depositing a second etch-stop layer that covers the conductive material layer.

In some embodiments, the forming of the connection layer further includes patterning the conductive material layer to form a conductive layer, the conductive layer being in contact with the side surface of the electrode layer and the reflector structure.

In some embodiments, the depositing of the first etch-stop material layer, the conductive material layer, and the second etch-stop layer each comprises a physical vapor deposition (PVD).

In some embodiments, the method further includes depositing an insulating structure in contact with the second etch-stop layer, and planarizing the insulating structure, the second etch-stop layer, and the first etch-stop layer, to expose the electrode layer.

Aspects of the present disclosure also include a BAW device. The BAW device includes a reflector structure over a piezoelectric layer, a dielectric layer over a surface of the reflector structure, an electrode structure over the dielectric layer and in contact with the surface of the reflector structure, and a connection structure over the electrode structure, and in contact with the electrode structure and the surface of the reflector structure.

In some embodiments, the electrode structure includes an electrode seed layer having a first portion in contact with a side surface of the dielectric layer, and a second portion in contact with the surface of the reflector structure. The electrode structure may also include an electrode layer in contact with the electrode seed layer, the electrode layer having a first portion in contact with the first portion of the electrode seed layer, and a second portion in contact with the second portion of the electrode seed layer.

In some embodiments, the connection structure includes a first etch-stop layer over the electrode layer. The first etch-stop layer has a first portion in contact with the first portion of the electrode layer, and a second portion in contact with the second portion of the electrode layer. The connection structure may also include a conductive layer over the first etch-stop layer. The conductive layer has a first portion in contact with the first portion of the first etch-stop layer, a second portion in contact with the second portion of the first etch-stop layer, and a third portion in contact with a side surface of the electrode structure and the surface of the reflector structure.

In some embodiments, the connection structure further includes a second etch-stop layer over the conductive layer and the surface of the reflector structure.

In some embodiments, the electrode seed layer comprises aluminum nitride (AlN), and the electrode layer comprises tungsten (W) or aluminum copper (AlCu).

In some embodiments, the first etch-stop layer includes aluminum nitride (AlN).

In some embodiments, the second etch-stop layer includes aluminum nitride (AlN).

In some embodiments, the BAW device further includes an insulating structure in contact with the connection structure.

### BRIEF DESCRIPTION OF THE DRAWINGS

The accompanying drawing figures incorporated in and forming a part of this specification illustrate several aspects of the disclosure, and together with the description, serve to explain the principles of the disclosure.
**FIG. 1** illustrates an example structure of a BAW device, according to embodiments of the present disclosure.
**FIG. 2** illustrates a flowchart of an example process to form a BAW device, according to embodiments of the present disclosure.
**FIGS. 3A-3E** illustrates structures of the BAW device at different stages of an example process, according to embodiments of the present disclosure.
**FIGS. 4A** and **4B** show a comparison between scanning electron microscopy (SEM) images of an electrode layer grown on an ex-situ (existing) electrode seed layer and an electrode layer grown over an in-situ electrode seed layer, according to embodiments of the present disclosure.

### DETAILED DESCRIPTION

The following detailed description is illustrative in nature and is not intended to limit the scope, applicability, or configuration of inventive embodiments disclosed herein in any way. Rather, the following description provides practical examples, and those skilled in the art will recognize that some of the examples may have suitable alternatives. Embodiments will hereinafter be described in conjunction with the appended drawings, which are not to scale (unless so stated), wherein like numerals/letters denote like elements. However, it will be understood that the use of a number to refer to a component in a given drawing is not intended to limit the component in another drawing labeled with the same number. In addition, the use of different numbers to refer to components in different drawings is not intended to indicate that the different numbered components cannot be the same or similar to other numbered components. Examples of constructions, materials, dimensions and fabrication processes are provided for select elements and all other elements employ that which is known by those skilled in the art.

As used herein, the term "about" refers to a given amount of value that may vary based on the particular technology node associated with the semiconductor device. Based on a particular technology node, the term "about" can refer to a given amount of value that varies, for example, within 10-30% of the value (e.g., ± 10%, ± 20%, or ± 20% of that value, or ± 30%).

Reference will now be made in greater detail to various embodiments of the subject matter of the present disclosure, some embodiments of which are illustrated in the accompanying drawings.

As used herein, the term "coupled to" or the like refers to two objects being connected to each other in some way. The coupling between the two objects can include any suitable connection such as electrical, mechanical, thermal, optical, etc. In various embodiments, the term "coupled to" is interchangeable with the term "connected to".

High quality factor in BAW devices (e.g., BAW resonators) requires low electrical and material losses. Existing BAW resonators may have improved electrical losses or improved material losses, but it is difficult to lower both the electrical and material losses. The BAW devices include BAW resonators of which the electrical performance are characterized by Qs (measure of how good a resonator is in amplifying the motion) and Qp (measure of how efficient the resonator is in impeding the motion). Having high values for both Qs and Qp are important to make an efficient filter. These Q's majorly depends on ohmic losses driven by sheet resistance of electrodes and material losses driven by the piezoelectric thin film growth (texture, roughness etc.). High frequency filters/resonators often require very thin layers of both piezoelectric and electrodes (frequency scale as 1/thickness). This leads to an inevitable need to connect electrodes to the Bragg reflector to reduce ohmic losses to boost Qs. Whereas to boost Qp, the piezoelectric film must be of high quality in terms of orientation and roughness. For example, existing BAW devices employs electrical connection between electrodes and the Bragg reflector to improve the effectiveness of a BAW resonator. Such configuration can reduce ohmic loss and increases Qs. For example, U.S. Patent Publication No. 2023/0074357 A1 and U.S. Patent Publication No. 2024/0235513 A1 discuss a BAW resonator of which the Bragg reflector is electrically connected to the electrodes.

Another factor affecting Q is the loss from materials, mainly piezoelectric material. Piezoelectric film growth depends strongly on the nature of the incoming layers such as electrodes. Even minor roughness or imperfections in growth orientation in the incoming layer can directly affect the growth of the piezoelectric material. Therefore, it is important to make sure that along with the parameters for the piezoelectric film growth itself, even other layers are also optimized. One such important layer is the seed for electrodes (BE-SEED) which is typically AlN (a dielectric). The quality of BE-SEED directly affects the piezo growth.

However, in existing BAW resonators, BE-SEED is often deposited *ex-situ* and undergoes fabrication steps to form the connection between the Bragg reflector and the electrode. Such fabrication process directly affects the quality of the growth of the piezoelectrical material. As a result, the piezoelectric material of the BAW resonator may have impaired quality, causing material loss to the BAW resonator.

Embodiments of the present disclosure provide a BAW device (e.g., a BAW resonator), formed by a novel fabrication process, that enable simultaneous reduction in both the electrical and material losses, improving the performance of the BAW device. The BAW device has the configuration of which the electrode(s) is/are electrically connected to a respective reflector structure (e.g., a Bragg reflector). The electrode seed layer may have significantly reduced crystallite sizes. Piezoelectric thin film, formed over the electrode layer that grown from the electrode seed layer may have improved quality by virtue of in-situ deposition of electrode seed layer, at the same time enabling low electrical/ohmic losses. To facilitate the electrical connection between the electrode layer and a reflector structure of the BAW device, a connection structure is formed in contact with the electrode layer and the reflector structure. Specifically, instead of patterning an electrode seed material layer to form an electrode seed layer prior to the deposition of an electrode material layer, the electrode material layer is deposited on the "unpatterned" electrode seed material layer. The electrode material layer and the electrode seed material layer are then patterned in a same process to form an electrode structure that. The connection structure, including a conductive material, is then formed extending over the electrode structure and onto the reflector structure. Specifically, the conductive material is in contact with a side surface of the electrode structure and the top surface of the reflector structure to facilitate the electrical connection.

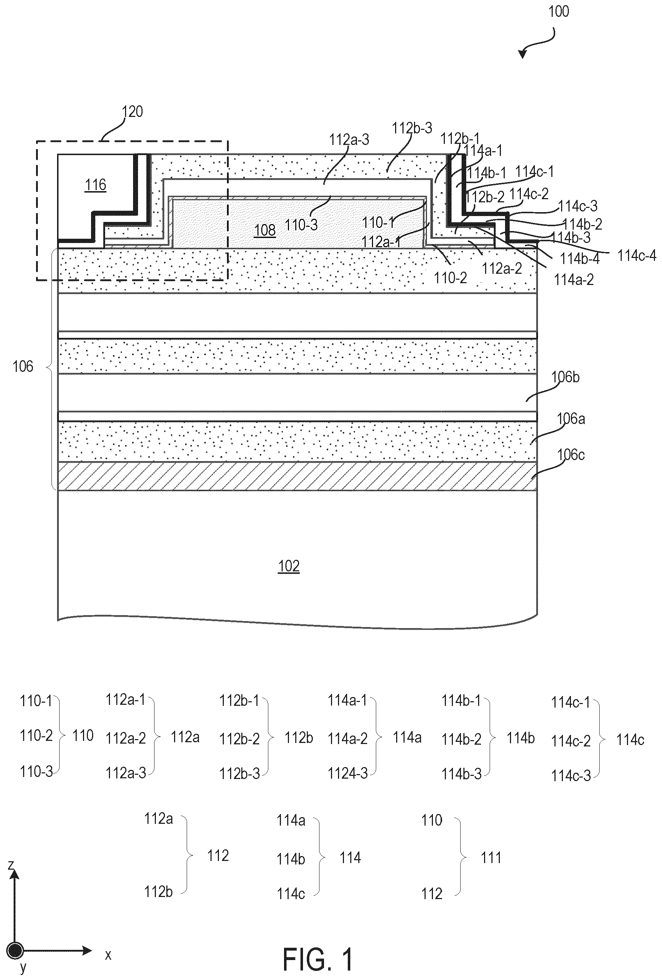

FIG. 1 shows a cross-sectional view of a BAW device 100 with a connection structure 114, according to embodiments of the present disclosure. BAW device 100 includes a substrate 102 and a reflector structure 106 over substrate 102. Substrate 102 may include a suitable material such as a semiconductor material (e.g., silicon), glass, plastic, or any other suitable material. Reflector structure 106 (e.g., a Bragg reflector) may include one or more first stack layers 106a and one or more second stack layers 106b stacking alternatingly in the z-direction. First stack layer 106a and second stack layer 106b may include materials of low resistance (e.g., high conductivity) and different acoustic impedances. In some embodiments, first stack layer 106a includes metal of high acoustic impedance, and second stack layer 106b includes metal of low acoustic impedance. For example, first stack layer 106a includes tungsten (W) and second stack layer 106b includes aluminum copper (AlCu). In some embodiments, reflector structure 106 includes a plurality of first stack layer 106a/second stack layer 106b pairs. In some embodiments, a seed layer for second stack layer 106b, may be disposed between a first stack layer 106a and a second stack layer 106b. In some embodiments, the seed layer includes titanium tungsten (TiW). Depending on the design, the number of pairs may vary to achieve a desirable acoustic reflectivity. For example, the number of pairs may be at least 2. In some embodiments, reflector structure 106 includes a protection layer 106c disposed between first stack layer 106a/second stack layer 106b pairs and substrate 102. Protection layer 106c may include a suitable high-voltage breakdown dielectric and/or aluminum nitride (AlN), and may provide static electricity (ESD) protection for BAW device 100.

BAW device 100 may include a dielectric layer 108 over and in contact with a top surface (e.g., the surface away from substrate 102) of reflector structure 106 (e.g., first stack layer 106a). In some embodiments, a distance between an edge of dielectric layer 108 and a respective edge of reflector structure 106 is at least 1 µm to allow sufficient space for the forming of a connection structure. Dielectric layer 108 can acoustically decouple reflector structure 106 from the electrode layer (described as follows), and can maximize the acoustic energy storage in the piezoelectric layer (described as follows) and the electrode structure, thus resulting in higher/improved acoustic coupling and quality factor. Dielectric layer 108 may include a suitable dielectric material such as silicon oxide, silicon nitride, silicon oxynitride, or a combination thereof. In some embodiments, dielectric layer 108 includes silicon oxide.

BAW device 100 may also include an electrode structure 111 over dielectric layer 108. Electrode structure 111 may include an electrode seed layer 110 over and in contact with dielectric layer 108 and reflector structure 106. Electrode seed layer 110 may include a first portion 110-1 over and in contact with a side surface of dielectric layer 108, a second portion 110-2 over and in contact with the top surface of reflector structure106, and a third portion over and in contact with a top surface (e.g., facing away from substrate 102) of dielectric layer 108. In some embodiments, electrode seed layer 110 covers dielectric layer 108 and partially reflector structure 106. Electrode seed layer 110 may include suitable seed materials such as aluminum nitride (AlN), titanium (Ti), titanium nitride (TiN), or any combination of them. In some embodiments, electrode seed layer 110 includes AlN.

Electrode structure 111 may include an electrode layer 112 in contact with electrode seed layer 110. Electrode layer 112 may include a suitable conductive material, and may be a single-layered structure or a multi-layered structure. In some embodiments, electrode layer 112 is a multi-layered structure, and includes a first electrode sub-layer 112a and a second electrode sub-layer 112b. First electrode sub-layer 112a and second electrode sub-layer 112b may include different conductive materials which may include one or more of copper (Cu), tungsten (W), aluminum copper (AlCu), molybdenum (Mo), and/or platinum (Pt). In some embodiments, first electrode sub-layer 112a includes AlCu, and second electrode sub-layer 112b includes W.

First electrode sub-layer 112a may include a first portion 112a-1 in contact with first portion 110-1 of electrode seed layer 110, a second portion 112a-2 in contact with second portion 110-2 of electrode seed layer 110, and a third portion 112a-3 in contact with third portion 110-3 of electrode seed layer 110. In some embodiments, first electrode sub-layer 112a is over electrode seed layer 110 and exposing (e.g., not covering) a side surface of electrode seed layer 110. Second electrode sub-layer 112b may include a first portion 112b-1 in contact with first portion 112a-1 of first electrode sub-layer 112a, a second portion 112b-2 in contact with second portion 112a-2 of first electrode sub-layer 112a, and a third portion 112b-3 in contact with third portion 112a-3 of first electrode sub-layer 112a. In some embodiments, second electrode sub-layer 112b is over first electrode sub-layer 112a and exposing (e.g., not covering) side surfaces of first electrode sub-layer 112a and electrode seed layer 110.

For ease of description, first portions 112a-1, 112b-1, and 110-1 are collectively referred to as a first portion of electrode structure 111, second portions 112a-2, 112b-2, and 110-2 are collectively referred to as a second portion of electrode structure 111, and third portions 112a-3, 112b-3, and 110-3 are collectively referred to as a third portion of electrode structure 111. Side surfaces of seed layer 110, first electrode sub-layer 112a, and second electrode sub-layer 112b are collectively referred to as a side surface of electrode structure 111.

BAW device 100 may further include a connection structure 114 over electrode structure 111 and in contact with the side surface of electrode structure 111 and the top surface of reflector structure 106, such that electrode structure 111 and reflector structure 106 are electrically connected. Connection structure 114 may include a first etch-stop layer 114a, a conductive layer 114b, and a second etch-stop layer 114c. In various embodiments, conductive layer 114b may be in contact with reflector structure 106, and the side surfaces of electrode seed layer 110, first electrode sub-layer 112a, and second electrode sub-layer 112b.

As shown in FIG. 1, first etch-stop layer 114a may be over electrode layer 112 and in contact with second electrode sub-layer 112b. First etch-stop layer 114a may include a first portion 114a-1 in contact with the first portion of electrode layer 112 (e.g., 112b-1), and a second portion 114a-2 in contact with the second portion of electrode layer 112 (e.g., 112b-2). In some embodiments, first etch-stop layer 114a is over electrode layer 112. First etch-stop layer 114a may expose (e.g., not cover) the side surface of electrode structure 111, and expose a top surface of second electrode sub-layer 112b (e.g., the third portion 112b-3).

Conductive layer 114b may be over first etch-stop layer 114a and in contact with at least the side surface of electrode structure 111. Conductive layer 114b may include a first portion 114b-1 in contact with first portion 114a-1 of first etch-stop layer 114a, a second portion 114b-2 in contact with the second portion 114a-2 of first etch-stop layer 114a, and a third portion 114b-3 in contact with the side surface of electrode structure 111 (e.g., side surfaces of electrode seed layer 110, first electrode sub-layer 112a, and second electrode sub-layer 112b). In some embodiments, conductive layer 114b includes a fourth portion 114b-4 that extends (e.g., in the x-y plane) to be in contact with the top surface of reflector structure 106. In some embodiments, conductive layer 114b is planarized and exposes first etch-stop layer 114a (e.g., the first portion 114a-1).

Second etch-stop layer 114c may be over conductive layer 114b. In some embodiments, second etch-stop layer 114c may include a first portion 114c-1 in contact with first portion 114b-1 of conductive layer 114b, a second portion 114c-2 in contact with the second portion 114b-2 of conductive layer 114b, and a third portion 114c-3 in contact with the third portion 114b-3 of conductive layer 114b. In some embodiments, second etch-stop layer 114c includes a fourth portion 114c-4 that extends to cover fourth portion 114b-4. Second etch-stop layer 114c may expose a top surface (e.g., facing away from substrate 102) of conductive layer 114b (e.g., the first portion 114b-1).

BAW device 100 may further includes an insulating structure 116 surrounding and in contact with connection structure 114. The top surface (e.g., away from substrate 102) of insulating structure 116,the top surface (e.g., away from substrate 102) of connection structure 114, and third portion of second electrode sub-layer 112b-3 may be substantially coplanar, e.g., by a planarization process. As shown in FIG. 1, connection structure 114 may exposes second electrode sub-layer 112b-3, and the top surface of insulating structure 116 is substantially coplanar with the top surface (e.g., away from substrate 102) of third portion 112b-3 of second electrode sub-layer 112b. Second etch-stop layer 114c may prevent conductive layer 114b from being over etched during the planarization that exposes conductive layer 114b. First etch-stop layer 114c may protect electrode layer 112 during the planarization process.

In some embodiments, first etch-stop layer 114a and second etch-stop layer 114c each includes a suitable etch-stop material for the planarization process. For example, first etch-stop layer 114a and second etch-stop layer 114c may include a suitable material that has sufficiently high etch selectivity to silicon oxide (for chemical mechanical polishing or CMP) and the electrode material (e.g., tungsten), such as AlN. In some embodiments, first etch-stop layer 114a and second etch-stop layer 114c each includes AlN. Conductive layer 114b may include any suitable conductive material such as copper (Cu), tungsten (W), aluminum copper (AlCu), molybdenum (Mo), and/or platinum (Pt), silver (Ag), gold (Au), or so. In some embodiments, conductive layer 114b includes W. Insulating structure 116 includes a suitable insulating material such as silicon oxide, silicon nitride, silicon oxynitride, tetraethoxysilane (TEOS), or any combination. In some embodiments, insulating structure 116 includes TEOS.

Although not shown, a piezoelectric layer may be disposed on the planarized top surfaces of connection structure 114 and insulating structure 116. The piezoelectric layer may include a suitable piezoelectric material such as aluminum nitride (AlN), zinc oxide (ZnO), aluminum scandium nitride (AlScN) and/or other suitable materials. In some embodiments, the piezoelectric layer includes AlN. In some embodiments, by in-situ deposition of electrode seed layer (e.g., 110), the film quality of electrode layer 112 and the subsequent piezoelectric layer can be improved.

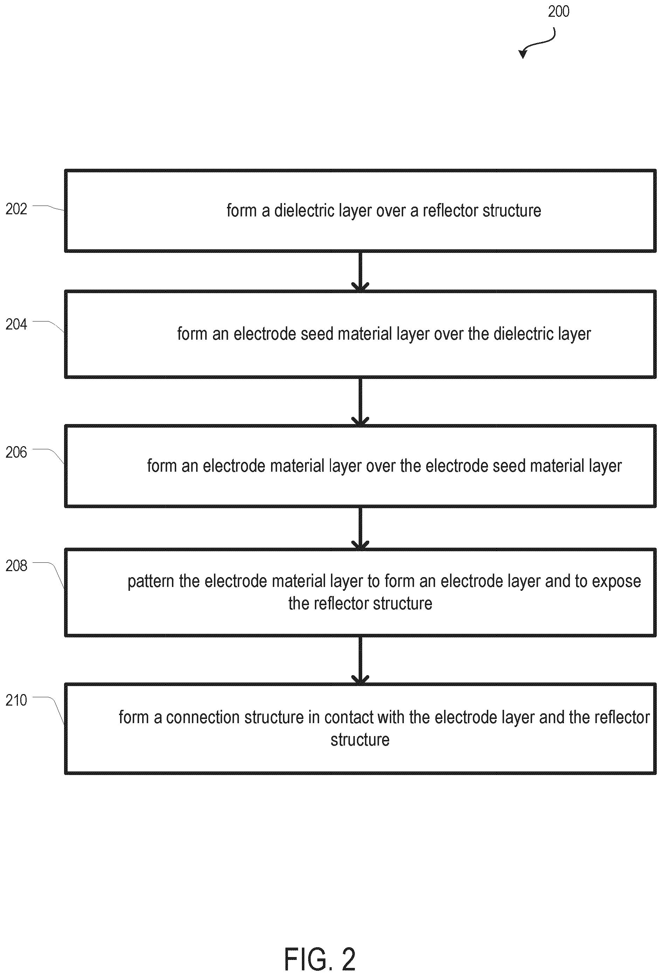

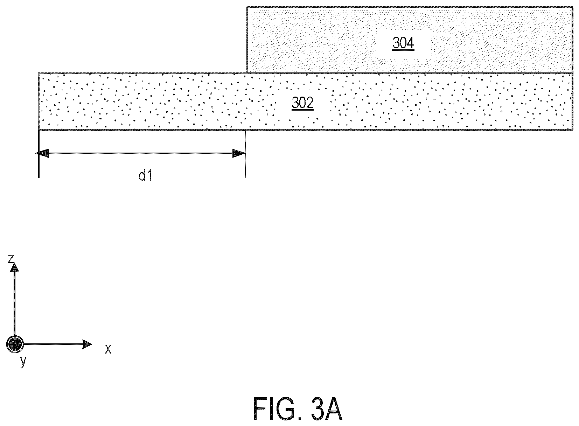

FIG. 2 is a flowchart of a method 200 for forming a BAW device, according to some embodiments of the present disclosure. The BAW device may be an example of BAW device 100. Method 200 is merely an example, and is not intended to limit the present disclosure beyond what is explicitly recited in the claims. Additional operations can be provided before, during, and after the method 200, and some operations described can be replaced, eliminated, or moved around for additional embodiments of method 200. For ease of illustration, method 200 is now described in view of FIGS. 3A-3E, which shown structures of part of BAW device 120 as circled in FIG. 1.

At step 202, a dielectric layer is formed over a reflector structure. FIG. 3A shows a corresponding structure.

As shown in FIG. 3A, a dielectric layer 304 is formed over a reflector structure 302, which may be formed over a substrate. Reflector structure 302 may be configured to reflect an acoustic wave propagating in a piezoelectric layer, and may include a plurality of pairs of first stack layer/second stack layer. In some embodiments, first stack layer includes W, and second stack layer includes AlCu. Dielectric layer 304 may include a suitable dielectric layer such as silicon oxide. In some embodiments, the forming of reflector structure 302 and dielectric layer 304 may include photolithography, dry etch, wet etch, chemical vapor deposition (CVD), physical vapor deposition (PVD), atomic layer deposition (ALD), electroplating, electroless plating, sputtering, soldering, grinding, chemical mechanical polishing (CMP), and/or a cleaning process. In some embodiments, a dielectric material layer is deposited over reflector structure 302 by one or more of CVD, PVD, and ALD. The dielectric material layer is then patterned to form dielectric layer 304 that exposes part of the top surface of reflector structure 302.

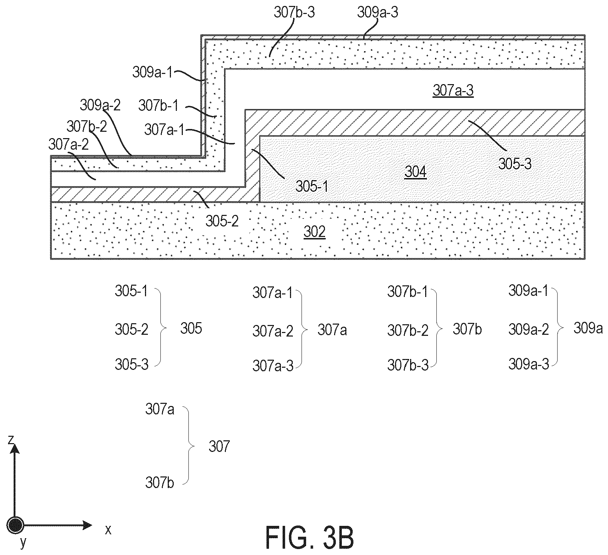

At step 204, an electrode seed material layer is formed over the dielectric layer. At step 206, an electrode material layer is formed over the electrode seed material layer. FIG. 3B shows a corresponding structure.

As shown in FIG. 3B, an electrode seed material layer 305 is deposited over dielectric layer 304 and reflector structure 302. Electrode seed material layer 305 may be in contact with the top surface (e.g., away from reflector structure 302) and side surface of dielectric layer 304, and the top surface (e.g., away from reflector structure 302) of reflector structure 302. In some embodiments, electrode seed layer 305 includes a first portion 305-1 in contact with the side surface of dielectric layer 304, a second portion 305-2 in contact with the top surface of reflector structure 302, and a third portion 305-3 in contact with the top surface of dielectric layer 304. An electrode material layer 307 may then be deposited over electrode seed material layer 305. Electrode material layer 307 may cover and be in contact with electrode seed material layer 305. Electrode material layer 307 includes a first electrode material sub-layer 307a in contact with electrode seed material layer 305, and a second electrode material sub-layer 307b in contact with first electrode material sub-layer 307a. As shown in FIG. 3B, in some embodiments, first electrode material sub-layer 307a may include a first portion 307a-1 in contact with first portion 305-1 of electrode seed material layer 305, a second portion 307a-2 in contact with second portion 305-2 of electrode seed material layer 305, and a third portion 307a-3 in contact with third portion 305-3 of electrode seed material layer 305. In some embodiments, second electrode material sub-layer 307b may include a first portion 307b-1 in contact with first portion 307a-1 of first electrode material sub-layer 307a, a second portion 307b-2 in contact with second portion 307a-2 of first electrode material sub-layer 307a, and a third portion 307b-3 in contact with third portion 307a-3 of first electrode material sub-layer 307a.

In some embodiments, electrode seed material layer 305 includes AlN, first electrode material sub-layer 307a includes Wu, and second electrode material sub-layer 307b includes AlCu. In some embodiments, the deposition of electrode seed material layer 305 and electrode material layer 307 may include CVD, PVD, ALD, electroplating, electroless plating, sputtering, or a combination thereof. In some embodiments, the deposition of electrode seed material layer 305 includes an in-situ PVD, and the deposition of electrode material layer 307 includes a PVD.

In some embodiments, a first etch-stop material layer 309a is deposited over electrode material layer 307. First etch-stop material layer 309a may include a first portion 309a-1 in contact with first portion 307b-1, a second portion 309a-2 in contact with second portion 307b-2, and a third portion 309a-3 in contact with third portion 307b-3. In some embodiments, first etch-stop material layer 309a includes AlN, and can be deposited via CVD, PVD, ALD, sputtering, or a combination thereof.

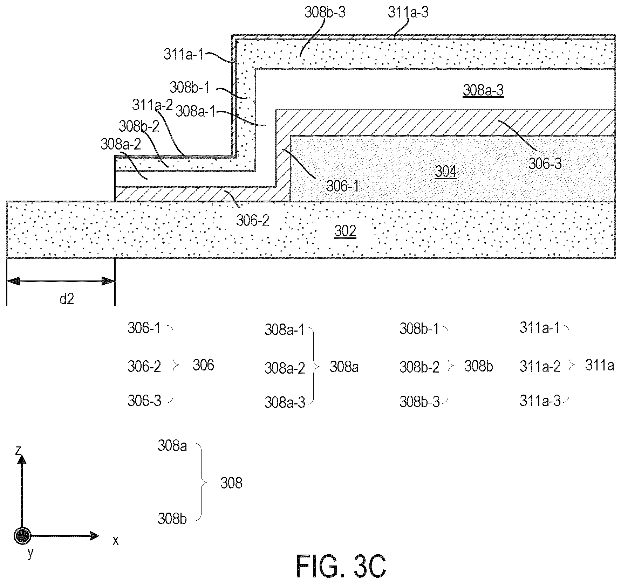

At step 208, the electrode material layer is patterned to form an electrode layer and to expose the reflector structure. FIG. 3C shows a corresponding structure.

As shown in FIG. 3C, electrode seed material layer 305, electrode material layer 307, and first etch-stop material layer 309a may be patterned in a same patterning process to expose part of the top surface of reflector structure 302. In some embodiments, part of second portions 305-2, 307a-2, 307b-2, and 309a-2 of electrode seed material layer 305, electrode material layer 307, and first etch-stop material layer 309a may be removed, respectively, to expose part of reflector structure 302 that is away from dielectric layer 304. Electrode seed layer 306, electrode layer 308, and patterned first etch-stop material layer 311a may be formed. First portions (e.g., 305-1, 307a-1, 307b-1, and 309a-1) may respectively form first portions (e.g., 306-1, 308a-1, 308b-1, and 311a-1) of electrode seed layer 306, first electrode sub-layer 308a, second electrode sub-layer 308b, and patterned first etch-stop material layer 311a. Third portions (e.g., 305-3, 307a-3, 307b-3, and 309a-3) may respectively form third portions (e.g., 306-3, 308a-3, 308b-3, and 310a-3) of electrode seed layer 306, first electrode sub-layer 308a, second electrode sub-layer308b, and patterned first etch-stop layer 311a. The patterned second portions (e.g., 305-2, 307a-2, 308a-2, and 309a-2) may respectively form second portions (e.g., 306-2, 308a-2, 308b-2, and 310a-2) of electrode seed layer 306, first electrode sub-layer 308a, second electrode sub-layer 308b, and patterned first etch-stop material layer 311a. In some embodiments, side surfaces of electrode seed layer 306, electrode layer 308, and patterned first etch-stop layer 311a are exposed, e.g., along the z-direction. In some embodiments, the patterning of electrode seed material layer 305, electrode material layer 307, and first etch-stop material layer 309a includes photolithography, dry etch, and/or wet etch. Firs electrode sub-layer 308a and second electrode sub-layer 308b may be referred to as electrode layer 308.

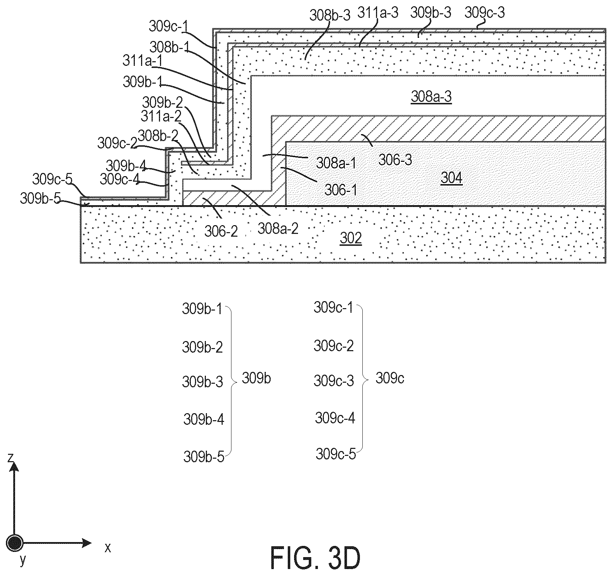

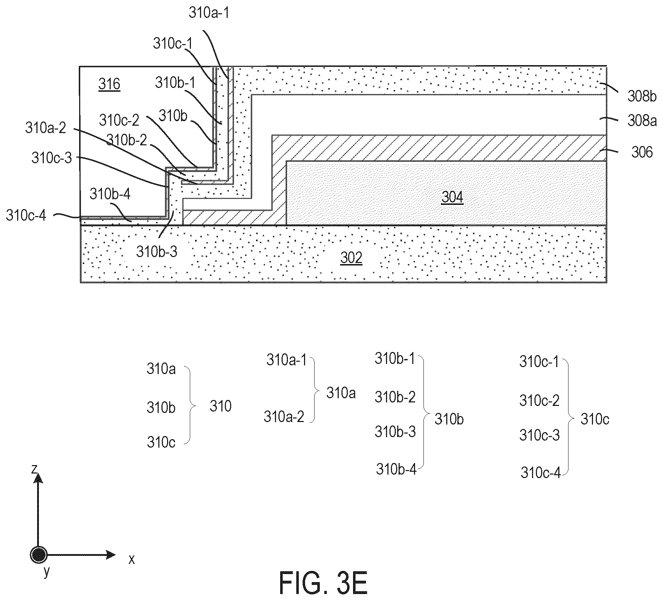

At step 210, a connection structure is formed in contact with the electrode layer and the reflector structure. FIGS. 3D and 3E show corresponding structures.

As shown in FIG. 3D, a conductive material layer 309b may be deposited over patterned first etch-stop material layer 311a. Conductive material layer 309b may be in contact with the exposed side surfaces of electrode seed layer 306, electrode layer 308, and patterned first etch-stop material layer 311a, and the top surface of reflector structure 302. Conductive material layer 309b may include a suitable conductive material, such as W. Accordingly, conductively material layer 309b may electrically connect electrode layer 308 and reflector structure 302. In some embodiments, conductive material layer 309b includes a first portion 309b-1 in contact with first portion 311a-1, a second portion 309b-2 in contact with second portion 311a-2, and a third portion 309b-3 in contact with third portion 311a-3. Conductive material layer 309b may also include a fourth portion 309b-4 in contact with the side surfaces of electrode seed layer 306, electrode layer 308, and patterned first etch-stop material layer 311a. In some embodiments, conductive material layer 309b include a fifth portion 309b-5 in contact with the top surface of reflector structure 302. Fifth portion 309b-5 may be in contact with fourth portion 309b-4 to facilitate the electrical connection between electrode layer 308 and reflector structure 302.

A second etch-stop material layer 309c may then be deposited over conductive material layer 309b. In some embodiments, second etch-stop material layer 309c is in contact with conductive material layer 309b, and includes a first portion 309c-1 covering first portion 309b-1, a second portion 309c-2 covering second portion 309b-2, a third portion 309c-3 covering third portion 309b-3, a fourth portion 309c-4 covering fourth portion 309b-4, and a fifth portion 309c-5 covering fifth portion 309b-5. In some embodiments, second etch-stop layer 310c includes AlN. The deposition of conductive material layer 309b may include at least one of CVD, PVD, ALD) electroplating, electroless plating, sputtering, and/or soldering. The deposition of second-etch stop material layer 309c may include at least one of CVD, PVD, ALD, sputtering, or a combination thereof. In some embodiments, the deposition of first etch-stop material layer 309a, conductive material layer 309b, and second etch-stop material layer 309c include PVD.

As shown in FIG. 3E, an insulating material structure may then be deposited surrounding and in contact with second etch-stop material layer 309c. The insulating material structure may include TEOS, and the deposition may include at least one of CVD, PVD, ALD, sputtering, spin-on coating, or a combination thereof.

The insulating material structure, second etch-stop material layer 309c, conductive material layer 309b, and patterned first etch-stop material layer 311a may be planarized to expose the conductive material and electrode layer 308. As shown in FIG. 3E, parts of second etch-stop material layer 309c,conductive material layer 309b, and patterned first etch-stop material layer 311a are removed. The patterned second etch-stop material layer 309c may form a second etch-stop layer 310c, the patterned conductive material layer 309b may form a conductive layer 310b, and patterned first etch-stop material layer 311a may form a first etch-stop layer 310a. First etch-stop layer 310a may include a first portion 310a-1 in contact with first portion 308b-1 of electrode layer 308, a second portion 310a-2 in contact with second portion 308b-2 of electrode layer 308. Conductive layer 310b may include a first portion 310b-1 in contact with first portion 310a-1, a second portion 310b-2 in contact with second portion 310a-2, a third portion 310b-3 in contact with the side surfaces of electrode layer 308, electrode seed layer 306, and reflector structure 302, and a fourth portion 310b-4 in contact with and extending on the top surface of reflector structure 302. Second etch-stop layer 310c may include a first portion 310c-1 in contact with first portion 310b-1, a second portion 310c-2 in contact with second portion 310b-2, a third portion 310c-3 in contact with third portion 310b-3, and a fourth portion 310c-4 in contact with fourth portion 310b-4. First etch-stop layer 310a, conductive layer 310b, and second etch-stop layer 310c may form a connection structure 310. The planarized insulating material structure may form an insulating structure 316. In some embodiments, the planarization process includes wet etch, dry etch, and/or CMP.

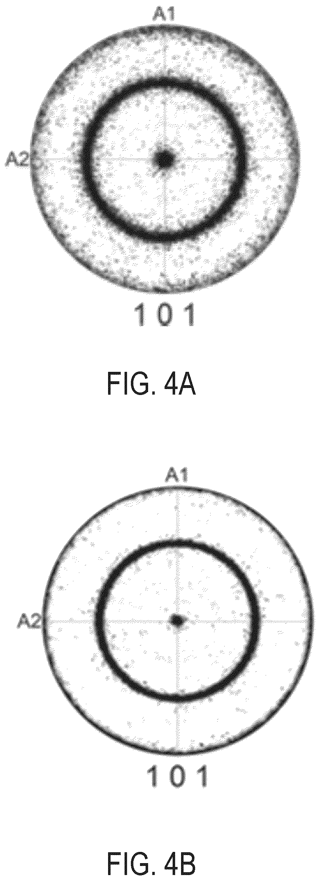

FIG. 4A and 4B show comparison of SEM results between a first electrode layer (4A) grown over ex-situ deposited electrode seed layer and a second electrode layer (4B) grown over in-situ deposited electrode seed layer in this disclosure. FIG. 4A shows electron backscatter diffraction (EBSD) of metal electrode where only about 60% crystals are oriented within 3-degree to the thermodynamically stable orientation of the metal. However, for a high-quality film, this number should be greater than 80%. FIG. 4B shows that the metal electrodes grow in a well oriented direction. This is reflected in EBSD of electrode as shown in FIG. 4B where greater than 90% of the grains are oriented towards the thermodynamically stable orientation.

Therefore, from one perspective there has been described a method for forming a BAW device. The BAW device includes forming a dielectric layer over a reflector structure, forming an electrode seed material layer over the dielectric layer, forming an electrode material layer over the electrode seed material layer, patterning the electrode material layer to form an electrode layer and to expose the reflector structure, and forming a connection layer in contact with the electrode layer and the reflector structure.

Further examples of feature combinations taught by the present disclosure are set out in the following numbered clauses.

Clause 1. A method for forming a bulk acoustic wave (BAW) device, comprising: forming a dielectric layer over a reflector structure; forming an electrode seed material layer over the dielectric layer; forming an electrode material layer over the electrode seed material layer; patterning the electrode material layer to form an electrode layer and to expose the reflector structure; and forming a connection layer in contact with the electrode layer and the reflector structure.

Clause 2. The method of clause 1, wherein the forming of the electrode seed material layer comprises depositing the electrode seed material layer to cover a top surface and a side surface of the dielectric layer, and the reflector structure.

Clause 3. The method of clause 2, wherein the electrode seed material layer comprises aluminum nitride (AlN).

Clause 4. The method of clause 2 or 3, wherein the depositing of the electrode seed material layer comprises an in-situ physical vapor deposition (PVD).

Clause 5. The method of any preceding clause, wherein the forming of the electrode material layer comprises depositing the electrode material layer to cover a top surface and a side surface of the electrode seed material layer, and the reflector structure.

Clause 6. The method of clause 5, wherein the depositing of the electrode material layer comprises: depositing a copper aluminum (AlCu) layer in contact with the electrode seed material layer; and depositing a tungsten (W) layer in contact with the copper aluminum layer.

Clause 7. The method of clause 6 or 7, wherein the depositing of the copper aluminum layer and the tungsten layer each comprises a physical vapor deposition (PVD).

Clause 8. The method of any preceding clause, wherein the forming of the connection layer comprises: depositing a first etch-stop material layer over the electrode material layer; and patterning the first etch-stop material layer and the electrode seed material layer in a same etching process that patterns the electrode material layer to expose the reflector structure, forming an electrode seed layer and a first etch-stop layer.

Clause 9. The method of clause 8, wherein the forming of the connection layer further comprises: depositing a conductive material layer over the electrode layer, the conductive material layer being in contact with the side surface of the electrode layer and the reflector structure; and depositing a second etch-stop layer that covers the conductive material layer.

Clause 10. The method of clause 9, wherein the forming of the connection layer further comprises patterning the conductive material layer to form a conductive layer, the conductive layer being in contact with the side surface of the electrode layer and the reflector structure.

Clause 11. The method of clause 9 or 10, wherein the depositing of the first etch-stop material layer, the conductive material layer, and the second etch-stop layer each comprises a physical vapor deposition (PVD).

Clause 12. The method of clause 11, further comprising: depositing an insulating structure in contact with the second etch-stop layer; and planarizing the insulating structure, the second etch-stop layer, and the first etch-stop layer to expose the electrode layer.

Clause 13. A bulk acoustic wave (BAW) device, comprising a reflector structure over a piezoelectric layer; a dielectric layer over a surface of the reflector structure; an electrode structure over the dielectric layer and in contact with the surface of the reflector structure; and a connection structure over the electrode structure, and in contact with the electrode structure and the surface of the reflector structure.

Clause 14. The BAW device of clause 13, wherein the electrode structure comprises: an electrode seed layer having a first portion in contact with a side surface of the dielectric layer, and a second portion in contact with the surface of the reflector structure; and an electrode layer in contact with the electrode seed layer, the electrode layer having a first portion in contact with the first portion of the electrode seed layer, and a second portion in contact with the second portion of the electrode seed layer.

Clause 15. The BAW device of clause 14, wherein the connection structure comprises: a first etch-stop layer over the electrode layer, the first etch-stop layer having a first portion in contact with the first portion of the electrode layer, and a second portion in contact with the second portion of the electrode layer; and a conductive layer over the first etch-stop layer, the conductive layer having a first portion in contact with the first portion of the first etch-stop layer, a second portion in contact with the second portion of the first etch-stop layer, and a third portion in contact with a side surface of the electrode structure and the surface of the reflector structure.

Clause 16. The BAW device of clause 15, wherein the connection structure further comprises a second etch-stop layer over the conductive layer and the surface of the reflector structure.

Clause 17. The BAW device of clause 14, 15 or 16, wherein: the electrode seed layer comprises aluminum nitride (AlN); and the electrode layer comprises tungsten (W) or aluminum copper (AlCu).

Clause 18. The BAW device of clause 15 or any clause dependent thereon, wherein the first etch-stop layer comprises aluminum nitride (AlN).

Clause 19. The BAW device of clause 16 or any clause dependent thereon, wherein the second etch-stop layer comprises aluminum nitride (AlN).

Clause 20. The BAW device of any of clauses 13 to 19, further comprising an insulating structure in contact with the connection structure.

Those skilled in the art will recognize improvements and modifications to the disclosed embodiments of the present disclosure. All such improvements and modifications are considered within the scope of the concepts disclosed herein and the claims that follow.

## Claims

1. A method for forming a bulk acoustic wave (BAW) device, comprising:
forming a dielectric layer over a reflector structure;
forming an electrode seed material layer over the dielectric layer;
forming an electrode material layer over the electrode seed material layer;
patterning the electrode material layer to form an electrode layer and to expose the reflector structure; and
forming a connection layer in contact with the electrode layer and the reflector structure.

2. The method of claim 1, wherein the forming of the electrode seed material layer comprises depositing the electrode seed material layer to cover a top surface and a side surface of the dielectric layer, and the reflector structure.

3. The method of claim 2, wherein the electrode seed material layer comprises aluminum nitride (AlN).

4. The method of claim 2 or 3, wherein the depositing of the electrode seed material layer comprises an in-situ physical vapor deposition (PVD).

5. The method of any preceding claim, wherein the forming of the electrode material layer comprises depositing the electrode material layer to cover a top surface and a side surface of the electrode seed material layer, and the reflector structure.

6. The method of claim 5, wherein the depositing of the electrode material layer comprises:
depositing a copper aluminum (AlCu) layer in contact with the electrode seed material layer; and
depositing a tungsten (W) layer in contact with the copper aluminum layer.

7. The method of claim 6, wherein the depositing of the copper aluminum layer and the tungsten layer each comprises a physical vapor deposition (PVD).

8. The method of any preceding claim, wherein the forming of the connection layer comprises:
depositing a first etch-stop material layer over the electrode material layer; and
patterning the first etch-stop material layer and the electrode seed material layer in a same etching process that patterns the electrode material layer to expose the reflector structure, forming an electrode seed layer and a first etch-stop layer.

9. The method of claim 8, wherein the forming of the connection layer further comprises:
depositing a conductive material layer over the electrode layer, the conductive material layer being in contact with the side surface of the electrode layer and the reflector structure; and
depositing a second etch-stop layer that covers the conductive material layer.

10. The method of claim 9, wherein the forming of the connection layer further comprises patterning the conductive material layer to form a conductive layer, the conductive layer being in contact with the side surface of the electrode layer and the reflector structure.

11. The method of claim 9 or 10, wherein the depositing of the first etch-stop material layer, the conductive material layer, and the second etch-stop layer each comprises a physical vapor deposition (PVD).

12. The method of claim 11, further comprising:
depositing an insulating structure in contact with the second etch-stop layer; and
planarizing the insulating structure, the second etch-stop layer, and the first etch-stop layer to expose the electrode layer.

13. A bulk acoustic wave (BAW) device, comprising:
a reflector structure over a piezoelectric layer;
a dielectric layer over a surface of the reflector structure;
an electrode structure over the dielectric layer and in contact with the surface of the reflector structure; and
a connection structure over the electrode structure, and in contact with the electrode structure and the surface of the reflector structure.

14. The BAW device of claim 13, wherein the electrode structure comprises:
an electrode seed layer having a first portion in contact with a side surface of the dielectric layer, and a second portion in contact with the surface of the reflector structure; and
an electrode layer in contact with the electrode seed layer, the electrode layer having a first portion in contact with the first portion of the electrode seed layer, and a second portion in contact with the second portion of the electrode seed layer.

15. The BAW device of claim 14, wherein the connection structure comprises:
a first etch-stop layer over the electrode layer, the first etch-stop layer having a first portion in contact with the first portion of the electrode layer, and a second portion in contact with the second portion of the electrode layer; and
a conductive layer over the first etch-stop layer, the conductive layer having a first portion in contact with the first portion of the first etch-stop layer, a second portion in contact with the second portion of the first etch-stop layer, and a third portion in contact with a side surface of the electrode structure and the surface of the reflector structure.
